# EUROPÄISCHE PATENTANMELDUNG

(11) **EP 1 561 838 A1**
(43) Veröffentlichungstag der Anmeldung: **10.08.2005**
(21) Anmeldenummer: 04011490.2
(22) Anmeldetag: 14.05.2004
(51) Int. Cl.: C23C 14/56, C23C 14/34, H01L 51/40, H01J 37/34, F16K 11/02

(54) **Energie- und Medienanschluss für eine aus mehreren Kammern bestehende Beschichtungsanlage**

(30) Priorität: 09.02.2004 DE 102004006419
(71) Anmelder: Applied Films GmbH & Co. KG, 63755 Alzenau (DE)
(72) Erfinder: Hattendorf, Guido, 63636 Brachttal (DE); Rödling, Gert, 63179 Obertshausen (DE); Rist, Gerhard, 63505 Langenselbold (DE)
(74) Vertreter: Schickedanz, Willi, Dr. Dipl.-Ing.

(57) **Zusammenfassung**

Die Erfindung betrifft ein Energie- und Medienanschlussmodul für Beschichtungsanlagen. Dieses Modul dient zur Versorgung mit Kühlwasser, Druckluft, Prozessgasen, Signal-, Steuer- und Kathodenstrom. Es kann von nur einer Person in kurzer Zeit von einer Beschichtungskammer zur nächsten Beschichtungskammer entlang einer Beschichtungslinie umgesetzt werden. Außerdem ist es möglich, das Energieanschlussmodul ohne mechanische Demontage sämtlicher Anschlüsse von einer Beschichtungskammer für Wartungszwecke abzutrennen und zu versetzen.

## Beschreibung

Die Erfindung betrifft einen Energie- und Medienanschluss nach dem Oberbegriff des Patentanspruchs 1.

Beschichtungsanlagen, beispielsweise für Glas, weisen oft eine Kathode und eine Anode auf, zwischen denen eine Spannung anliegt, die ein Plasma erzeugt. Mit Hilfe dieses Plasmas werden bestimmte Stoffe auf dem Glas niedergeschlagen, sei es durch Sputtern oder ein anderes Verfahren. Beim Sputtern wird die Kathode sehr erhitzt, weil positiv geladene Teilchen aus dem Plasma auf ein mit der Kathode verbundenes Target auftreffen und aus diesem Atome oder Moleküle herausschlagen, die sich dann auf dem Glas niederschlagen.

Um die Erwärmung der Kathode in Grenzen zu halten, wird diese gekühlt, und zwar in der Regel mit einem flüssigen Medium, z. B. Wasser. Hierfür sind besondere Wasserzuleitungen erforderlich. Außer diesen Wasserzuleitungen werden auch noch Stromzuleitungen benötigt, um zwischen Kathode und Anode eine bestimmte Spannung anlegen zu können. Weiterhin sind Gaszuleitungen erforderlich, um Gase für die Erzeugung des Plasmas oder für eine chemische Reaktion bereitzustellen.

Bei den herkömmlichen Beschichtungsanlagen werden die verschiedenen Energie- und Medienanschlüsse auf die jeweils herzustellenden Beschichtungen zugeschnitten. Es werden also Kühlrohrzuleitungen und Spannungszuleitungen vorgesehen, die auf die jeweils verwendete Kathode ausgelegt sind.

Desgleichen werden spezielle Gaszuführungen für reaktives oder nicht-reaktives Sputtern an der jeweiligen Beschichtungsanlage angeordnet.

Eine Beschichtungsanlage besteht in der Regel aus mehreren Beschichtungskammern, die nebeneinander angeordnet sind. Soll nun eine Sputterkathode von einer Beschichtungskammer in eine andere Beschichtungskammer gebracht werden, müssen an der neuen Beschichtungskammer wieder die speziellen Zuleitungen durch Anschweißen etc. angebracht werden. Diese Anpassung einer Beschichtungskammer an eine neue Kathode ist mit sehr großem Aufwand verbunden.

Der Erfindung liegt deshalb die Aufgabe zugrunde, einen Energie- und Medienanschluss für Beschichtungsanlagen zu schaffen, der eine individuelle Anpassung an die jeweilige Beschichtungskammer nicht erfordert.

Diese Aufgabe wird gemäß den Merkmalen des Patentanspruchs 1 gelöst.

Der mit der Erfindung erzielte Vorteil besteht insbesondere darin, dass der Zeitaufwand für das Rekonfigurieren von Beschichtungsanlagen erheblich reduziert wird. Außerdem können die mobilen Energie- und Medienanschlussmodule von nur einer Person in kurzer Zeit und ohne größere Hilfsmittel von einer Beschichtungskammer zu einer anderen Beschichtungskammer bewegt werden. Auch die Wartung einer Beschichtungskammer wird vereinfacht, weil die Anschlussmodule von dieser Beschichtungskammer weggeschoben werden können.

Ein Ausführungsbeispiel der Erfindung ist in den Zeichnungen dargestellt und wird im Folgenden näher beschrieben. Es zeigen:
Fig. 1 eine Prinzipdarstellung eines Moduls für Energie- und Medienanschlüsse;
Fig. 2 eine Frontansicht eines Energie- und Medienanschluss-Moduls;
Fig. 3 eine Ansicht der Oberseite des in der Fig. 2 dargestellten Moduls;
Fig. 4 eine Seitenansicht des in den Fig. 2 und 3 dargestellten Moduls;
Fig. 5 eine perspektivische Ansicht des Moduls;
Fig. 6 eine Beschichtungsanlage mit zwei Modulen;
Fig. 7 einen vergrößerten Ausschnitt aus Fig. 6;
Fig. 8 einen Querschnitt durch eine Sputterkammer mit Kühlung;
Fig. 9 einen Längsschnitt durch die Sputterkammer gemäß Fig. 8.

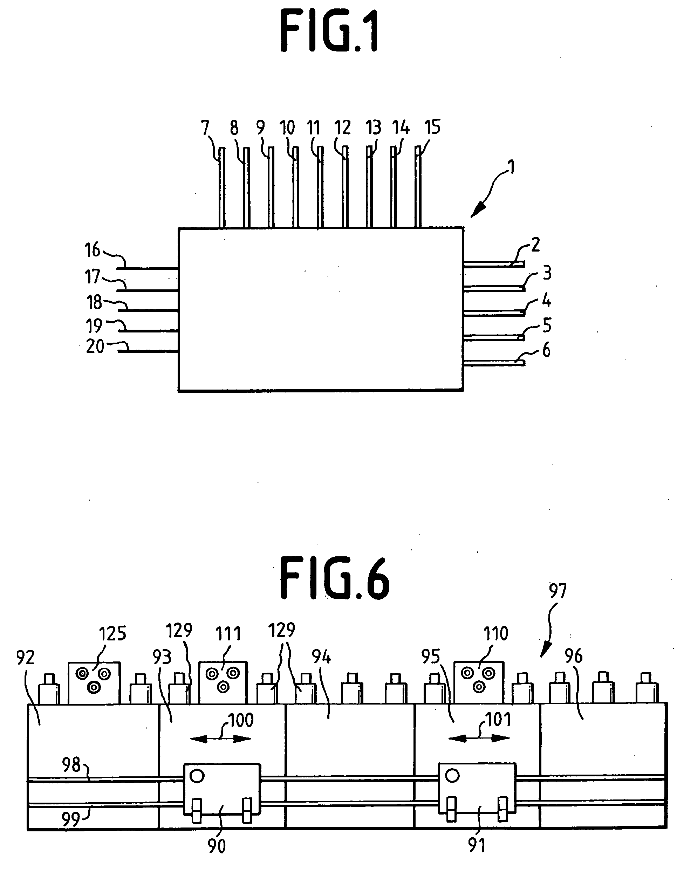

In der Fig. 1 ist ein Modul 1 für Energie- und Medienanschlüsse als Block dargestellt. Dieses Modul 1 weist mehrere Kühlmittelleitungen 2 bis 6 auf, beispielsweise eine Kühlmittelleitung 2 für die Kühlung einer Kathode mit Wasser und eine Kühlmittelleitung 3 für die Kühlung der Umgebung der Kathode sowie eine Kühlmittelleitung 4 für die Kühlung der Wand, die der Kathode gegenüberliegt. Mit 5 und 6 sind Reserve-Kühlmittelleitungen bezeichnet, die benötigt werden, um andere in einer Beschichtungsanlage befindliche Bauteile zu kühlen.

Außer den Kühlmittelleitungen 2 bis 6 weist das Modul 1 auch noch Gaszuführungsleitungen 7 bis 15 auf. Mit der Gaszuführungsleitung 7 wird beispielsweise Argon in die Prozess- oder Beschichtungskammer eingeführt, während mit der Gaszuführungsleitung 8 Stickstoff zugeführt wird. Analog dient die Gaszuführungsleitung 9 zum Zuführen von Sauerstoff. Mit den Gaszuführungsleitungen 10 bis 15 können im Bedarfsfall weitere Gase in die Prozesskammer eingebracht werden. Sie können auch als Ausblasleitungen oder Druckluftleitungen dienen.

Bei den Leitungen 16 bis 20 handelt es sich um Steuerleitungen und/oder um Energiezuführungsleitungen und/oder Messleitungen. So kann beispielsweise mit der Leitung 16 Spannung an die Kathode gelegt werden, durch welche ein Plasmaprozess in Gang gesetzt wird. Die Leitung 17 kann für die Regelung von Spannung, Strom oder elektrischer Leistung vorgesehen sein, und die Leitung 18 für die Energieversorgung eines Antriebs in der Prozesskammer. Mit den Leitungen 19, 20 können weitere Bauelemente mit elektrischer Energie versorgt oder gesteuert werden.

Das Modul 1 weist so viele Leitungen und Anschlüsse auf, wie für die Versorgung einer Prozesskammer maximal erforderlich sind. Werden einige Leitungen und Anschlüsse nicht benötigt, werden sie still geschaltet. Die Verbindungen von außen zum Modul 1 und vom Modul zu einer Prozesskammer sind lösbar ausgestaltet.

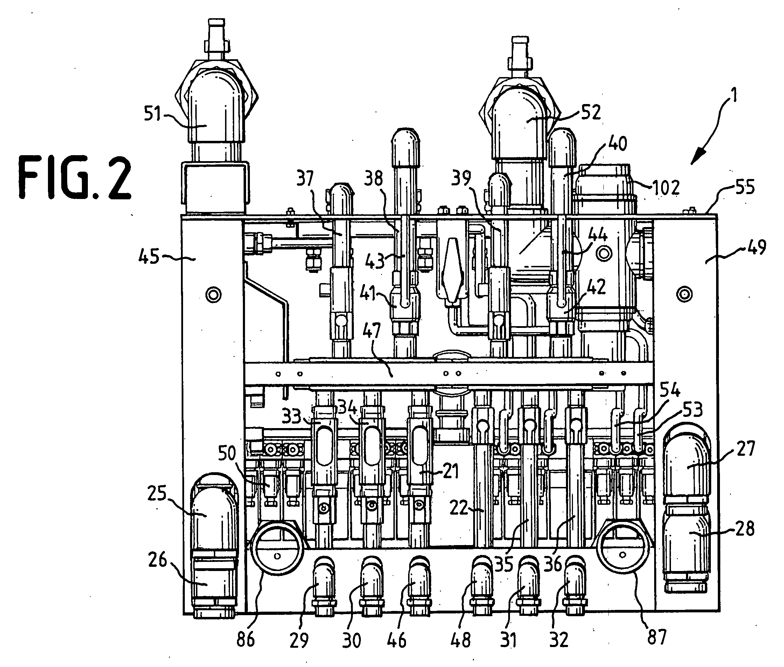

Die Fig. 2 zeigt ein konkretes Modul 1 in einer Frontansicht, das als Rahmenkonstruktion ausgebildet ist. Man erkennt hierbei einen Kühlwasserrücklauf 25 für eine erste Kathode, einen Kühlwasserrücklauf 26 für eine zweite Kathode, einen Kühlwasservorlauf 27 für die erste Kathode und einen Kühlwasservorlauf 28 für die zweite Kathode. Außerdem erkennt man einen Anschluss 51 für den Rücklauf der Kathodenkühlung und einen Anschluss 52 für den Vorlauf der Kathodenkühlung.

Da die Umgebung der Kathoden ebenfalls gekühlt wird, sind drei Rückläufe 29, 30, 46 und drei Vorläufe 48, 31, 32 für die Umgebungskühlung vorgesehen. Mit 86 und 87 sind elektrische Leistungsanschlüsse bezeichnet. Oberhalb der Rückläufe 29, 30, 46 befinden sich drei Durchflusswächter 33, 34, 21 und oberhalb der Vorläufe 48, 31, 32 drei Leitungsrohre 22, 35, 36. Mit 38 ist ein Anschluss für den Wasserrücklauf für die Umgebungskühlung bezeichnet, wobei dieser Rücklauf mit einem Absperrventil 41 versehen ist, das einen Absperrhebel 43 aufweist. Ein entsprechendes Absperrventil 42 mit einem zugeordneten Absperrhebel 44 liegt vor dem Anschluss 40 für den Wasservorlauf zur Kühlung der Umgebung einer Kathode. Zwischen zwei Blechen 45, 49 der Rahmenkonstruktion des Moduls 1 befindet sich ein querverlaufendes Verstärkungsblech 47. Oberhalb dieses Verstärkungsblechs 47 ist ein Druckverminderer 102 erkennbar. Die Oberseite des Moduls 1 ist mit 55 bezeichnet.

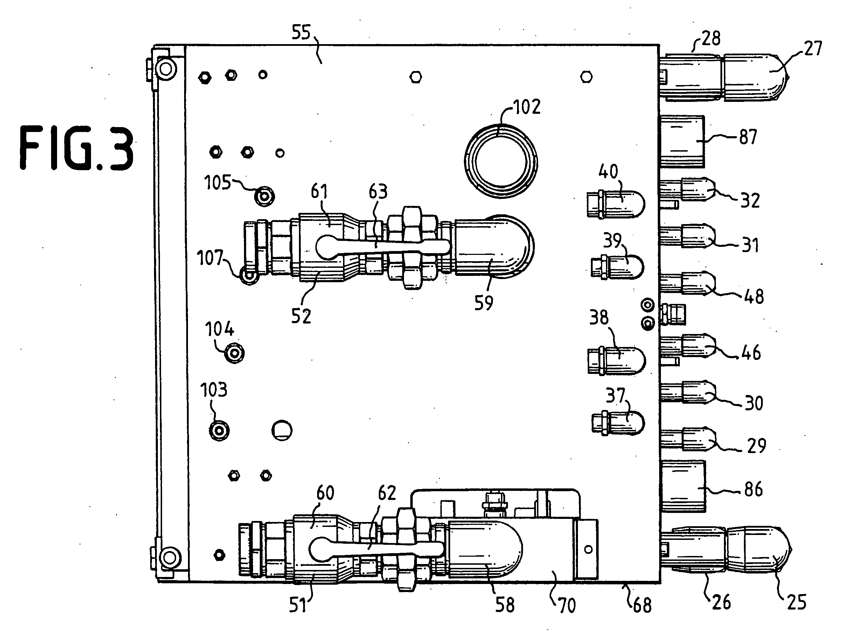

In der Fig. 3 ist die Oberseite 55 des Moduls 1 gemäß Fig. 2 dargestellt. Man erkennt hierbei wieder die Rückläufe 29, 30, 46 und die Vorläufe 48, 31, 32 der Umgebungskühlung sowie die Kühlwasseranschlüsse 26 bis 28 für die Kühlung der beiden Kathoden. Desgleichen erkennt man die elektrischen Leistungsanschlüsse 86, 87. Mit 37 ist eine Ausblasleitung bezeichnet, die sich neben dem Anschluss 38 für den Wasserrücklauf zur Kühlung der Kathodenumgebung befindet. Ein Anschluss für Druckluft 39 befindet sich neben dem Anschluss 40 für den Wasservorlauf zur Kühlung. An einen Rohrbogen 58, der sich auf einem Wasserverteiler 70 befindet, schließt sich eine Absperreinrichtung 60 mit einem Absperrhebel 62 an, wobei an die Absperreinrichtung 60 der Anschluss 51 für den Rücklauf der Kathodenkühlung anschließt. Gegenüber dem Rohrbogen 58 ist ein weiterer Rohrbogen 59 angeordnet, an den sich eine Absperreinrichtung 61 mit dem Absperrhebel 63 anschließt. An die Absperreinrichtung 61 ist der Anschluss 52 für den Vorlauf der Kathodenkühlung angeflanscht.

Mit 103, 104, 105, 107 sind Gasanschlüsse bezeichnet, während mit 102 der Druckminderer bezeichnet ist.

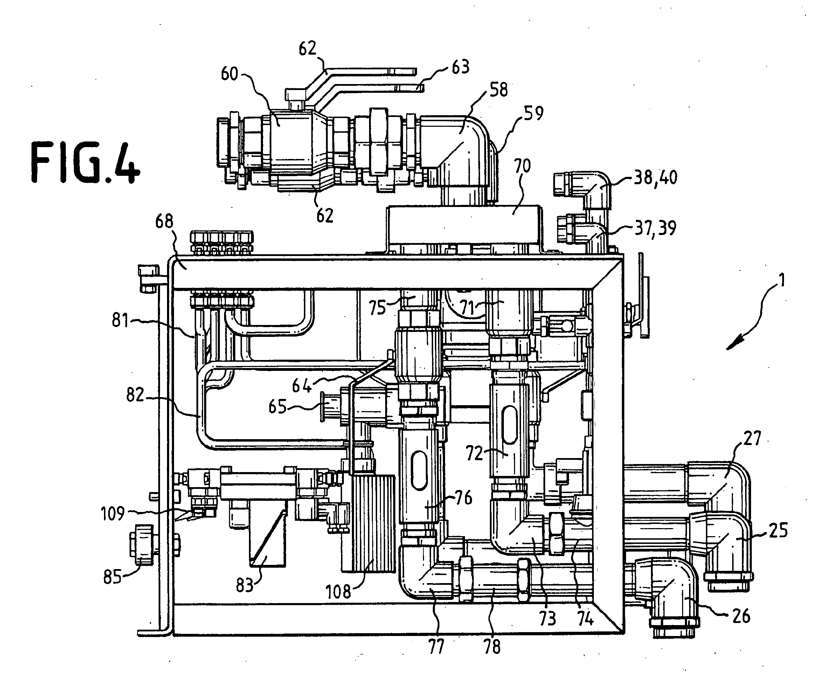

In der Fig. 4 ist das in den Fig. 2 und 3 dargestellte Modul 1 noch einmal in einer Ansicht auf die Seite 68 gezeigt. Man erkennt hierbei mehrere Gasleitungen 81, 82, von denen die Gasleitung 82 von einem Gaswahlschalter kommt. Ein Absperrventil 75 und ein Durchflusswächter 76 sind ebenfalls zu erkennen, wobei der Durchflusswächter 76 über einen Rohrbogen 77 zu einem Rohr 78 führt, das mit dem Kühlwasserrücklauf 26 für die zweite Kathode verbunden ist. Entsprechend ist der Durchflusswächter 72 über den Rohrbogen 73 und das Rohr 74 mit dem Kühlwasserrücklauf 25 für die erste Kathode verbunden. Mit dem Durchflusswächter 72 ist auch noch ein Absperrventil 71 verbunden, das zu dem Wasserverteiler 70 führt. Unterhalb eines Druckmessgeräts 108 befinden sich Gasflussregler 83 und darunter ein Gas-Handventil 109. In der Nähe des Absperrhebels 64 ist ein Vakuumflansch 65 für eine flexible Vakuumverbindung von der Anlage zum Druckmessgerät 108 vorgesehen. Der Durchflusswächter 72 und das Druckmessgerät 108 sowie der Gasflussregler 83 sind mit einer zentralen Steuerung verbunden.

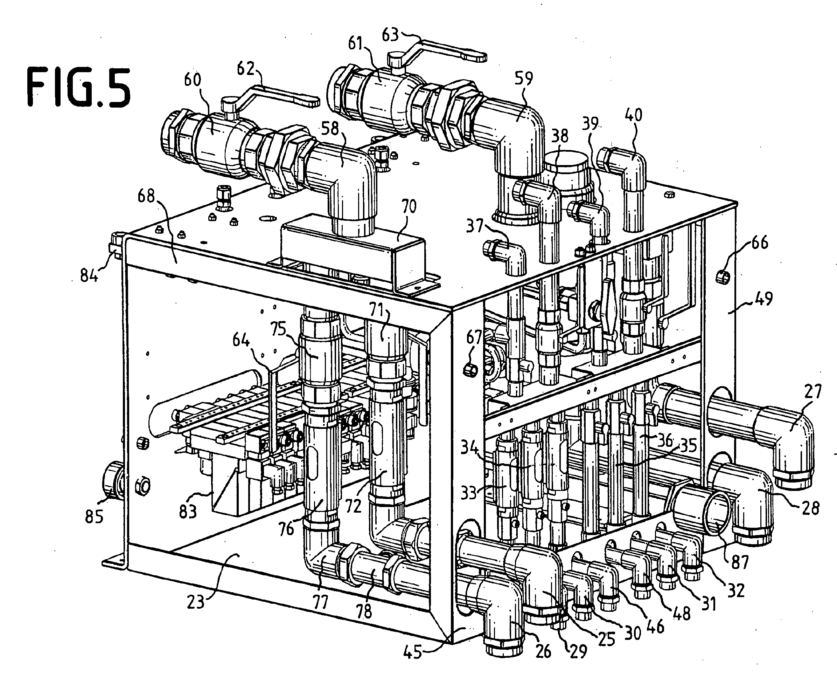

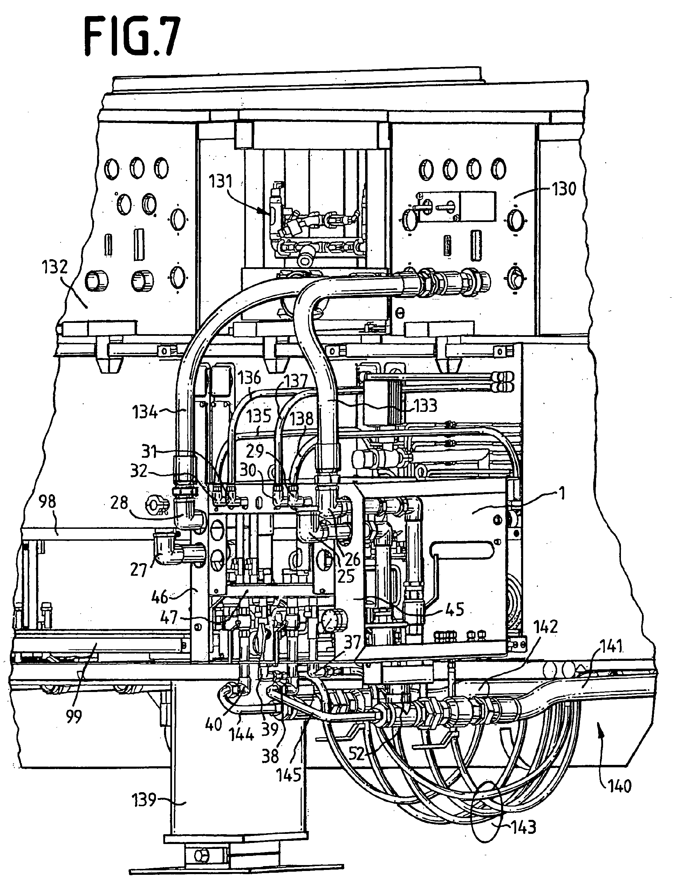

Fig. 5 zeigt die Vorrichtung der Fig. 2 bis 4 in einer perspektivischen Ansicht. Man erkennt hierbei auf der linken Seite die bereits aus den Fig. 3 und 4 bekannten Bauelemente, wobei die Bauelemente im Vergleich zu Fig. 3 um 180 Grad gedreht sind. Auf der rechten Seite sind die Bauelemente zu erkennen, die in Fig. 4 dargestellt sind, während die auf der Oberseite der Fig. 5 dargestellten Bauelemente bereits in der Fig. 3 gezeigt sind. Aus der Fig. 5 ist auch ersichtlich, dass mehrere Gasflussregler 83 hintereinander angeordnet sind. Auf den Blechen 45 und 49 befinden sich Anschlüsse 66, 67 für Manometer. Der Absperrhebel 64 für das Absperrventil 75 ist oberhalb der Gasflussregler 83 angeordnet. Mit 84 und 85 sind Transportrollen bezeichnet, die es ermöglichen, das Modul 1 entlang Schienen zu verschieben, die in Fig. 6 dargestellt sind. Bei dem Blech 23 handelt es sich um ein Abdeckblech, durch das keine Rohre oder dergleichen geführt sind.

Fig. 6 zeigt das Zusammenwirken von Modulen 90, 91 mit einer aus mehreren Kammern 92 bis 96 bestehenden Beschichtungsanlage 97.

Über die gesamte Beschichtungsanlage 97 erstrecken sich zwei Schienen 98 und 99. Mit den Schienen sind die Module 90, 91 derart gekoppelt, dass sie in die Richtungen der Pfeile 100, 101 bewegt werden können. Die Module 90, 91 sind hierbei in die Schienen 98, 99 eingehängt. Die Leitungen, die von außen an die Module angeschlossen werden, befinden sich auf der Unterseite der Beschichtungsanlage 97.

Die Ansichten der beiden in Fig. 6 gezeigten Module sind vereinfacht dargestellt. Sie entsprechen jedoch der Ansicht gemäß Fig. 2.

Bei der Darstellung gemäß Fig. 6 finden in den Kammern 93 und 95 Beschichtungsprozesse statt, während die Kammern 92, 94, 96 als Gastrennkammern dienen. Weitere Kammern können vorgesehen sein.

Wird in der Kammer 92 der Betrieb aufgenommen, während er in der Kammer 93 beendet ist, wird das Modul 90 von der Kammer 93 zur Kammer 92 verfahren. Es müssen jetzt nur noch die für den Beschichtungsvorgang wichtigen elektrischen und mechanischen Verbindungen hergestellt werden, und die Kammer 92 kann in Betrieb gesetzt werden. Die der Kammer 95 gegenüberliegende Seite eines Moduls 91 besitzt höchstens die Breite dieser Kammer 95.

Mit 110, 111 und 125 sind Kathodenabdeckhauben bezeichnet, während mit 129 Pumpeinrichtungen bezeichnet sind. Diese Pumpeinrichtungen 129 können statt auf der Oberseite der Beschichtungsanlage 97 auch an einer Seitenwand dieser Anlage 97 angeordnet sein.

Nachfolgend werden zwei Beispiele für die Verwendung des erfindungsgemäßen Energieund Medienanschlusses gegeben.

Eine so genannte Low-e-Schicht besteht z. B. aus der Schichtfolge Glassubstrat - TiO₂ - ZnO - AG- NiCr - Si₃N₄. Um diese Beschichtung zu erzielen, werden in der Beschichtungsanlage 97 nach einer Schleuse drei Titankathoden in Reihe angeordnet; dahinter folgt eine Gastrennkammer, an die sich eine Zinnkathode anschließt. Hinter einer weiteren Gastrennkammer folgt eine Silberkathode, an die sich eine Nickel-Chrom-Kathode anschließt. Hierauf folgt wieder eine Gastrennkammer. Vor der Ausschleusstation werden drei Siliziumkathoden angeordnet. Somit werden für das komplette Schichtsystem insgesamt neun Kathoden und drei Gastrennkammern benötigt. Außerdem müssen die für die reaktiven Prozesse erforderlichen Gase zugeführt werden.

Soll nun mit der Beschichtungsanordnung 97 statt einer Low-e-Schicht ein einfaches Solar-Control-Schichtsystem hergestellt werden, verändern sich die Verhältnisse grundlegend.

Ein solches Solar-Control-Schichtsystem besteht z. B. aus einer Edelstahlschicht, auf der Titannitrid aufgetragen wird. Hierfür benötigt man eine Edelstahlkathode vor der Gastrennkammer, auf die fünf Titankathoden folgen. Drei der vorhandenen Sputterstaionen und zwei Gastrennkammern werden hierfür nicht benötigt; sie werden stillgelegt. Das Stilllegen erfolgt hierbei einfach durch Abtrennen der elektrischen, pneumatischen und flüssigkeitszuführenden Zuleitungen durch Entkoppeln von Steckverbindungen.

Ein anderes Solar-Control-System besteht z. B. aus der Schichtfolge Zinnoxid - Chrom - Zinnoxid. In diesem Fall werden vier Zinnkathoden hintereinander angeordnet, gefolgt von einer Gastrennkammer. Dahinter folgen zwei Chromkathoden, eine Gastrennkammer und zwei weitere Zinnkathoden. Es sind also acht Kathoden und zwei Gastrennkammern im Einsatz. Eine Gastrennkammer und eine Kathode werden nicht benötigt. Auch hier kann durch Abkoppeln der entsprechenden Zuleitungen am Modul eine Anpassung an die neuen Verhältnisse erreicht werden.

In der Fig. 7 ist ein Teilbereich der Fig. 6 näher dargestellt. Dieser Teilbereich zeigt ein Modul 1 in einer Ansicht, die im Wesentlichen der Ansicht gemäß Fig. 2 entspricht, jedoch seitenvertauscht. Man erkennt hierbei eine Kathodenabdeckhaube 130, unter der sich eine in der Fig. 7 nicht dargestellte erste Sputterstation befindet. Außerdem ist eine Pumpabteilung 131 gezeigt. Eine zweite Sputterstation 132 befindet sich links von dieser Pumpabteilung 131. Unterhalb der Pumpabteilung 131 sind eine Kühlwasser-Rücklaufleitung 133 und eine Kühlwasser-Vorlaufleitung 134 dargestellt. Mit 135 bis 138 sind die Kühlschläuche für die Kühlung der Umgebung der Kathode bezeichnet. Unterhalb der Schienen 98, 99, auf denen das Modul 1 rollen kann, befindet sich ein Fuß 139, der zur Abstützung der Beschichtungsanlage dient.

Kühlflüssigkeit, Strom, Gase und Druckluft werden dem Modul 1 von der Unterseite 140 der Beschichtungsanlage aus zugeführt. Man erkennt aus Fig. 7, dass dort Kühlflüssigkeitsrohre 141, 142 und Schläuche 143 verlaufen.

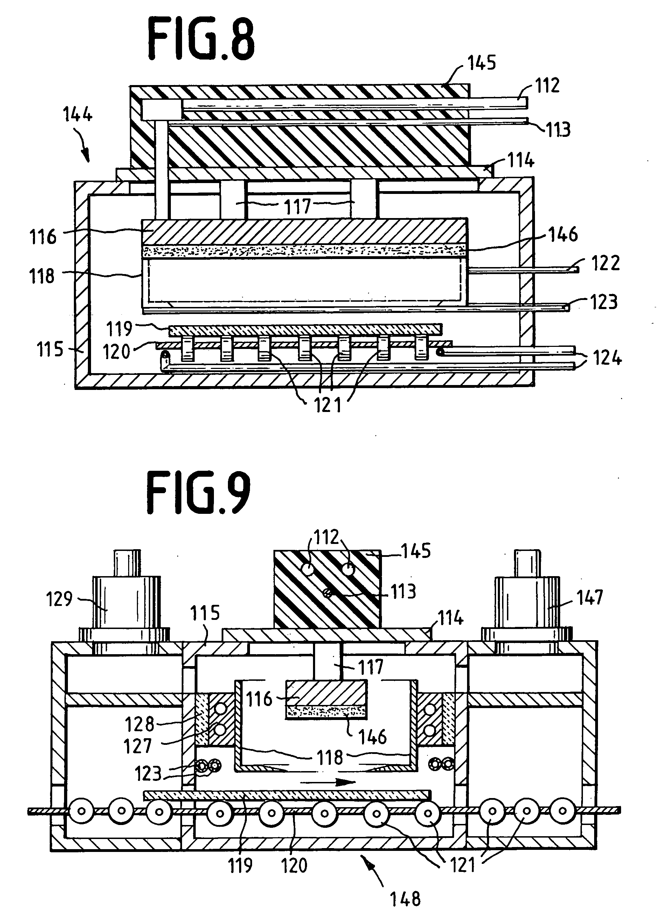

Die Fig. 8 zeigt in schematischer Darstellung einen Querschnitt durch eine Sputterkammer 144, die eine Kathodenabdeckhaube 145 aufweist, welche sich auf einem Anlagendeckel 114 befindet. Mit 112 ist ein Kühlwasservor- und -rücklauf bezeichnet. Unterhalb dieses Kühlwasservor- und ―rücklaufs 112 ist ein Anschluss 113 für eine Kathodenspannung angeordnet. Mit dem Anlagendeckel 114 ist eine Kathodenhalterung 117 verbunden, welche eine Kathode 116 mit Target 146 hält. Eine Anode 118 liegt an einem Anodenanschluss 122, wobei sich unterhalb der Anode eine Zuleitung 123 für Sputtergase befindet. Wiederum unterhalb der Anode 118 ist ein Substrat 119 angeordnet, bei dem es sich beispielsweise um eine zu beschichtende Glasscheibe handelt. Mit 120 ist ein Gegensputterblech 120 bezeichnet, das dann eine Bedeutung erlangt, wenn das Substrat 119 weggefahren und die Sputteranlage weiter betrieben wird. Das Wegfahren des Substrats 119 erfolgt mittels Transportrollen 121. Da sich das Gegensputterblech 120 während des Sputtervorgangs stark erwärmt, muss es gekühlt werden. Hierfür ist ein Vorund Rücklauf 124 für eine Kühlflüssigkeit vorgesehen. Es wird also sowohl die Kathode selbst gekühlt als auch ihre Umgebung, die hier durch das Gegensputterblech 120 und die Anode 118 realisiert ist.

Die Fig. 9 zeigt die Anordnung der Fig. 8 in einer um 90 Grad gedrehten Ansicht. Man erkennt hierbei Pumpeinrichtungen 129, 147 und Gaszuführungsleitungen 123. Außerdem erkennt man, dass die Anode 118 mit einer Halterung mit Kühlung 127 verbunden ist, wobei die Halterung 127 ihrerseits über eine Isolierung 128 mit einer Wand der Sputterkammer in Verbindung steht.

## Patentansprüche

1. Energie- und Medienanschluss für eine aus mehreren Kammern bestehende Beschichtungsanlage (97), wobei jede Kammer (92 bis 96) mit einer ihr individuell zugeordneten Sputterkathode bestückt ist und wobei eine vorgegebene Anzahl von Kühlmittelleitungen (2 bis 6) und elektrischen Leitungen (16 bis 20) in die Kammer (92 bis 96) führen, **dadurch gekennzeichnet, dass** der Energie- und Medienanschluss als Modul (1) ausgebildet ist und so viele Anschlüsse für Kühlmittelleitungen (2 bis 6) und elektrische Leitungen (16 bis 20) aufweist, wie für die Kammer mit den meisten Zuleitungen erforderlich sind, und dass das Modul (1) von einer Kammer zu einer anderen Kammer transportierbar ist.

2. Energie- und Medienanschluss nach Anspruch 1, **dadurch gekennzeichnet, dass** über die gesamte Beschichtungsanlage (97) ein Schienensystem (98, 99) geführt ist, mit dem wenigstens ein Modul (90, 91) koppelbar ist.

3. Energie- und Medienanschluss nach Anspruch 1, **dadurch gekennzeichnet, dass** die Verbindungen von außen zum Modul (1, 90) und vom Modul (1, 90) zur Kammer (93) lösbar sind.

4. Energie- und Medienanschluss nach Anspruch 1, **dadurch gekennzeichnet, dass** er würfelförmig ausgebildet ist, wobei die Seiten des Würfels im Wesentlichen gleich große Flächen besitzen.

5. Energie- und Medienanschluss nach Anspruch 1, **dadurch gekennzeichnet, dass** die Stromversorgung und die Steuerung über steckbare Verbindungen angeschlossen sind.

6. Energie- und Medienanschluss nach Anspruch 1, **dadurch gekennzeichnet, dass** die einer Kammer (95) gegenüberliegende Seite eines Moduls (91) höchstens die Breite dieser Kammer (95) besitzt.

7. Energie- und Medienanschluss nach Anspruch 1, **dadurch gekennzeichnet, dass** das Modul (1) als Rahmenkonstruktion ausgebildet ist.

8. Energie- und Medienanschluss nach Anspruch 1, **dadurch gekennzeichnet, dass** die Versorgungsleitungen, die von außen zum Modul führen, auf der Unterseite der Beschichtungsanlage (97) angeordnet sind.

9. Energie- und Medienanschluss nach Anspruch 1, **dadurch gekennzeichnet, dass** zusätzlich zu den Kühlmittelleitungen (2 bis 6) und den elektrischen Leitungen (16 bis 20) Gaszuführungsleitungen (7 bis 15) vorgesehen sind.

10. Energie- und Medienanschluss nach Anspruch 1, **dadurch gekennzeichnet, dass** zusätzlich zu den Kühlmittelleitungen (2 bis 6) und den elektrischen Leitungen (16 bis 20) Messleitungen vorgesehen sind.
